# EUROPÄISCHE PATENTSCHRIFT

(11) **EP 0 451 541 B1**
(45) Veröffentlichungstag und Bekanntmachung des Hinweises auf die Patenterteilung: **28.06.1995**
(21) Anmeldenummer: 91104096.2
(22) Anmeldetag: 16.03.1991
(51) Int. Cl.: H05K 3/46, H05K 1/16, H05K 1/18

(54) **Herstellung von mehrschichtigen Leiterplatten mit erhöhter Leiterbahnendichte**
Fabrication of multilayer circuit boards with increased conductor density
Fabrication de plaques de circuit multicouches à densité de conducteurs augmentée

(30) Priorität: 05.04.1990 CH 1149/90
(43) Veröffentlichungstag der Anmeldung: 16.10.1991
(73) Patentinhaber: Dyconex AG, CH-8052 Zürich (CH)
(72) Erfinder: Martinelli, Marco, CH-8413 Neftenbach (CH); Schmidt, Walter, Dr., CH-8050 Zürich (CH)
(74) Vertreter: Frei, Alexandra Sarah

(56) Entgegenhaltungen:
- EP-A- 0 111 890
- EP-A- 0 271 692
- US-A- 3 958 317
- US-A- 4 830 691
- 36TH ELECTRONIC COMPONENTS CONFERENCE, Seattle, US, 5. - 7. Mai 1986, Seiten 578-594; G.G. WERBIZKY et al.: "Circuit packaging for high power in high performance printed circuit boards"

## Beschreibung

Die Erfindung betrifft die Herstellung von mehrschichtigen Leiterplatten.

Es werden fortlaufend kleinere elektronische Baugruppen gefordert, die eine dichtere Bauweise aufweisen und dadurch schneller arbeiten können. Auch müssen immer höherfrequente Signale verarbeitet werden können. Diese Entwicklung fordert ständig kleinere Bauelemente, die auf den Leiterplatten weniger Raum beanspruchen, was bessere Montagemethoden und Leiterplatten mit immer enger beieinander liegenden Leiterbahnen erfordert. Wärmeableit- und Abschirmungsprobleme nehmen dadurch neue Dimensionen an und fordern neue Materialien und Herstellverfahren, auch auf dem Gebiete der Leiterplatten-Herstellung.

Bei den elektronischen Bauelementen sind beispielsweise die auf der Leiterplattenoberfläche montierbaren Baugruppen (surface mounted devices oder SMD) entwickelt worden, die nicht nur kleiner sind als ihre Vorgänger sondern für ihre Montage auch keine durchgehenden Löcher in den Leiterplatten und damit keinen Platz in den inneren Leiterplattenschichten benötigen.

Bei den Leiterplatten sind die üblichen Multilayerplatten so entwickelt worden, dass für die Leiterbahnen neben der Bestükkungsfläche weitere, innere Flächen angeordnet sind, sodass die Platten viel dichter bestückt werden können. Die einzelnen Lagen sind aber durch durchgehende Löcher (zum Teil auch Sacklöcher) in den Platten miteinander kontaktiert. Die durchgehenden Löcher werden in der Regel mechanisch gebohrt und durchplattiert und weisen damit einen nicht unterschreitbaren Durchmesser auf. Der Durchmesser der durchplattierten Kontaktierungslöcher bedingt direkt die notwendige Lötaugengrösse und damit den Auslegeraster der Leiterbahnenlagen. Solche Durchkontaktierungen beanspruchen ihrerseits Platz, auch in den Leiterbahnenlagen, wo sie keine Kontaktierung bewirken. Die Durchkontaktierungen begrenzen in einem gewissen Rahmen auch den Temperaturbereich, in dem elektronische Baugruppen eingesetzt werden können, denn die leitende Oberfläche der Kontakthülsen stellt einen thermisch kritischen Punkt der Wärmeausdehnung verschiedener aufeinanderliegender Materialien dar.

Eine Verringerung der Zahl der durchplattierten Kontaktierungslöcher lässt sich erreichen durch Verbinden benachbarter innerer Leiterbahnenlagen, sei es durch sogenannte "blind vias", das sind Kontaktierungskrater in einer Leiterbahnenlage, welche die Leiterschicht dieser Lage mit jener der darunterliegenden Lage verbinden, sei es durch durchgehende, plattierte Löcher durch eine doppelseitig kaschierte Folie. Beide Varianten sind beispielsweise beschrieben im Aufsatz "Circuit packaging for high power performance printed circuit boards"; G.G. Werbizky et al., 1986 IEEE 36th Electronic Components Conference, Seattle, Washington. Dieser zeigt auch ein Verfahren zur Herstellung mehrschichtiger Leiterplatten durch Vorfabrizieren von mehreren Leiterbahnenlagen bestehend aus einer Abfolge von Isolierschichten und Kupferschichten und anschliessendem Zusammenlaminieren der Vorfabrikate. Dem Verfahren haftet jedoch der Nachteil an, dass nur jeweils zwei Signal-Leiterschichten direkt verbunden werden können. Die restlichen Verbindungen zwischen Leiterschichten müssen nach wie vor mittels durchplattierter Löcher hergestellt werden. Zudem ist der ganze Querschnitt der Leiterplatte mit Leiterbahnen belegt, was Probleme für die Wärmeabfuhr mit sich bringt.

Es ist vorteilhaft, wenn die Kontaktierungen zwischen einzelnen Leiterbahnenlagen durch Bohrungen mit möglichst kleinem Durchmesser erzeugt werden, um bspw. den Querschnitt solcher Durchgänge zu reduzieren, wodurch der Auslegeraster der Leiterbahnenlagen bedeutend enger werden kann, und um Durchbohrungen durch das ganze Leiterplattenpaket zu vermeiden. Der engere Auslegeraster der Leiterbahnenlagen ermöglicht es, mit wenigen Leiterbahnenlagen höchste Verbindungsdichten zu erzielen, und neu entwickelte Verfahren erlauben es, die Leiterbahnenlagen auch bedeutend dünner zu realisieren. Dadurch wird es möglich, Leiterplatten beidseitig mit Leiterbahnenlagen auszustatten und mit höchster Dichte zu bestücken. Zusätzlich wird es durch diese verfeinerte Bauart innerhalb der geforderten Normen wie Leiterplattendicke und Leitungsimpedanz (bspw. 50Ω) möglich, dass der von durchgehenden Löchern weitgehend befreite innere Teil oder Kern der Leiterplatte, das sogenannte Core, neben den mechanischen Funktionen noch zusätzliche Aufgaben wie beispielsweise Wärmeableitung oder elektrische Pufferung übernehmen kann. Das heisst mit anderen Worten, dass auch Funktionen, die bis anhin Baugruppen und damit Platz auf der Bestückungsfläche erforderten, ins Innere der Leiterplatte verlegt werden können.

Solche Leiterplatten tragen dann ein- oder beidseitig eine Serviceebene (Gesamtheit der für den Signalaustausch zwischen den Bestückungselementen notwendigen Signalleiter) und Infrastrukturebenen (Speisung, Erdung und alle standardmässig notwendigen elektronischen Elemente wie Pull-up-Widerstände, Chipkondensatoren etc.) und zwar unter der Bestükungsebene, d.h. innerhalb der Platte. Die Bestückungsebenen, die fast keine Leiterbahnen tragen, werden vorteilhaft für die Bestückung mit surface mounted devices (SMD), Bandbestückung (TAB; tape automated bonding) oder ähnliche Verbindungstechniken ausgelegt. Dabei muss man sowohl Mischverfahren zur Bestückung mit teilweiser Durchsteckmontage, als auch nur einseitige Bestückung nicht ausschliessen.

Für die Kontaktierungen zwischen den einzelnen Leiterbahnenlagen können zum Beispiel durch chemisches oder mechanisches Mikrobohren oder durch Laserabtrag Löcher erzeugt werden, die sich nur zwischen den zu kontaktierenden Lagen erstrecken und so in allen anderen Lagen und auch auf der Bestückungsoberfläche keinen Platz beanspruchen. Der Durchmesser solcher Löcher beträgt dann höchstens einen Drittel vom Durchmesser von gebohrten Löchern, sodass der Abstand zwischen den Leiterbahnen entsprechend reduziert werden kann und sich für die Leiterbahnenlagen ein entsprechend engerer Raster ergibt.

Solcherart hergestellte Mehrlagen-Leiterplatten zeichnen sich also aus durch sehr dünne Leiterbahnenlagen, die auf einem entsprechend angepassten Core beidseitig aufgebracht sein können, und durch Bestückungsoberflächen, die für höchste Bestückungsdichte ausgelegt sind. Die Leiterplatten sind trotz der markanten Multifunktionalität bedeutend leichter als Mehrlagen-Leiterplatten geringerer Leistungsfähigkeit. Eine hohe mechanische Festigkeit ist mit handelsüblichen Corematerialien erreichbar, denn das Core ist praktisch über die ganze Ausdehnung der Leiterplatte durchgehend. Die thermische Ausdehnung, die bei hergebrachten Multilayern vor allem in der Richtung der Dicke der Platten (z-Richtung) problematisch ist und den Temperatureinsatzbereich der Platten begrenzt, wird durch die bedeutend kleinere Dicke der Leiterlagen über dem Core weniger kritisch, sodass der Temperatureinsatzbereich sich nach oben öffnet. Auch bei extrem hoher Packungsdichte der Bestückungselemente kann das Core so ausgebildet werden, dass eine ausreichende Wärmeableitung gewährleistet ist. Bei mindestens gleicher Verbindungsfunktion, thermischer und mechanischer Stabilität ist die Platte nach neuer Bauart wesentlich leichter und bietet freien Platz im Core, der für Einbauelemente nutzbar ist. Während bei herkömmlichen Multilayern um 70% des Volumens für die Verbindungen benötigt werden, stehen in der neuen Leiterplatte mindestens 50% des Volumens für das Core zur Verfügung.

Durchgehende Löcher durch die Leiterplatte sind nur noch notwendig für Kontaktierungen zwischen den Leiterbahnenlagen der beiden gegenüberliegenden Oberflächen der Leiterplatten, für Kontaktierungen zwischen den Leiterbahnenlagen und den im Core eingebauten Elementen und für die Montage von Steckern und anderen Elementen nach dem Durchsteckmontageverfahren. Nicht zu umgehende, durchgehende Löcher können aber so angeordnet werden, dass sie nur einen kleinen Teil der Leiterplatte betreffen.

Im folgenden soll an einem Beispiel die Herstellung einer solchen Leiterplatte beschrieben werden. Zur Illustration dienen die nachfolgend aufgeführten Figuren:
- **Fig. 1**: zeigt einen Übersichtsquerschnitt durch eine Mehrlagen-Leiterplatte.
- **Fig. 2**: zeigt einen Detailquerschnitt durch eine Mehrlagen-Leiterplatte.
- **Fig. 2A**: zeigt einen vergrösserten Ausschnitt aus Figur 2.
- **Fig. 3**: zeigt eine Aufsicht auf eine beispielsweise Leitungsführung auf der Serviceebene der Leiterplatte und
- **Fig. 4A**: zeigt eine Aufsicht auf eine beispielsweise Leitungsführung in der Speiseleiter- oder Erdleiterlage der Leiterplatte und
- **Fig. 4B**: den zugehörigen Querschnitt.
- **Fig. 5**: zeigt ein Beispiel für die Ausgestaltung der Kernschicht (Core) der Mehrlagen-Leiterplatte mit zusätzlichen Infrastrukturfunktionen, im speziellen mit einem integriertem Folien-Kondensator.
- **Fig. 6**: zeigt ein weiteres Beispiel für die Ausgestaltung des Cores, hier mit einem Folien-Widerstand.
- **Fig. 7**: zeigt ein weiteres Beispiel für die Ausgestaltung des Cores, hier mit einem Chipkondensator.
- **Fig. 8**: zeigt ein Beispiel für die Integration von trimmbaren Dünnschichtwiderständen auf einem Substrat und deren Kontaktierung mit den Leiterbahnenlagen der Leiterplatte.

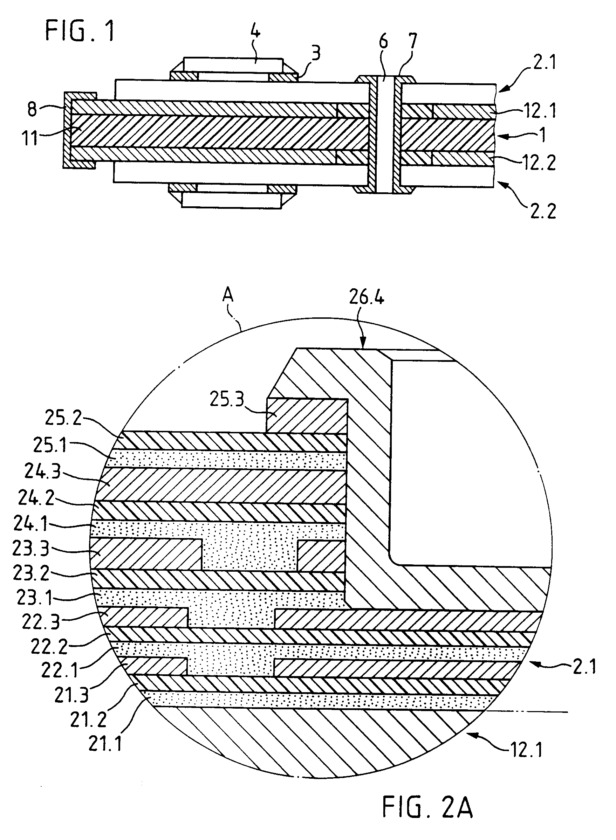

**Figur 1** zeigt einen Übersichtsquerschnitt durch eine, die beschriebenen Vorteile aufweisende Leiterplatte, aus der ihre Schichtung ersichtlich ist. Das tragende Element der Leiterplatte ist ein Core 1, das in dieser beispielhaften Ausführungsform aus zwei Substratfolien 12.1 und 12.2 besteht, die mit einer Zwischenschicht 11 zusammengepresst sind. Beidseitig von diesem Core 1 liegen die aus mehreren Leiterbahnenlagen bestehenden Schichten 2.1 und 2.2 auf, die alle Leiterbahnenlagen der Serviceebene und der Infrastrukturebene für die darüber montierten Bestückungselemente umfassen. Die Bestückungsoberflächen bestehen aus gedruckten Schaltungen (Padlage), die vor allem die Montagepads 3 für die Bestückungselemente und deren Verbindungen zu den unteren Ebenen (Infrastruktur- und Serviceebene) beinhalten. Diese Padlage ist mit Bauelementen 4 (bspw. SMD) bestückt. Schematisch ist auch ein durch die ganze Leiterplatte durchgehendes Loch 6 mit der entsprechenden Durchplattierung 7 und die Kantenmetallisierung 8 der Leiterplatte dargestellt.

Typische Abmessungen einer solchen Leiterplatte im Querschnitt wären, bei einer standardmässigen Gesamtdicke von ca. 1,8mm, je 250 bis 450»m für die beidseitigen, aus mehreren Leiterbahnenlagen bestehenden Schichten 2.1 und 2.2 und ca. 1 bis 1,5mm für das Core 1.

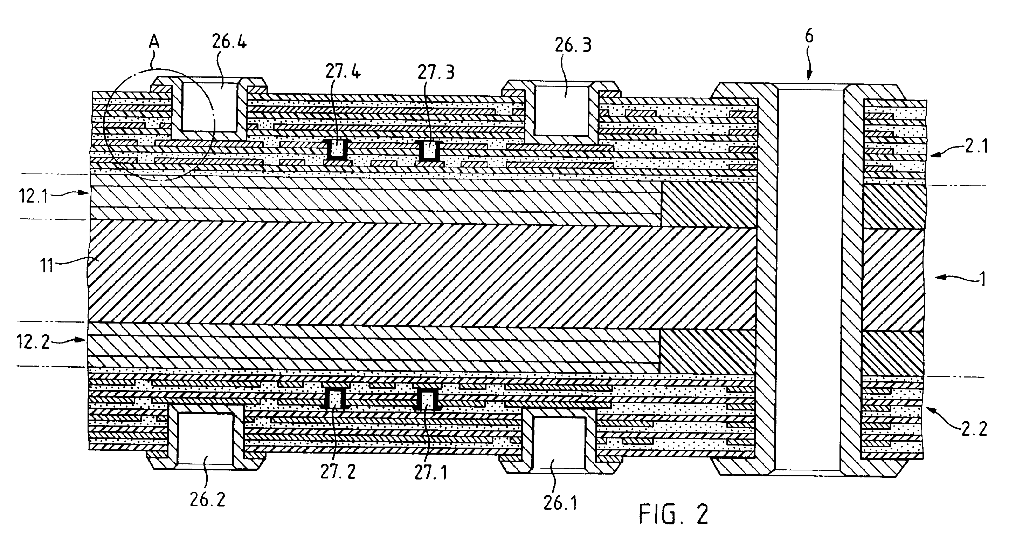

**Figur 2** zeigt einen detaillierten Querschnitt durch eine Ausführungsform der erfindungsgemässen Leiterplatte, mit Details aus dem Kreis A in Figur 2A.

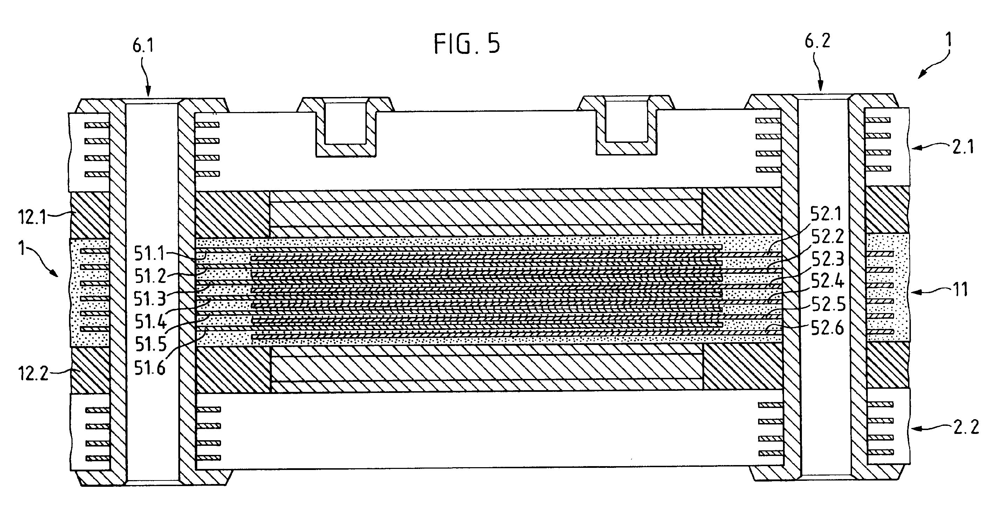

Das Core 1 besteht auch hier aus zwei Substratfolien 12.1 und 12.2, die mit einer Zwischenschicht 11 zusammengepresst sind. Die Dreischichtigkeit des Cores kann vorteilhaft sein für die Herstellung der Leiterplatte, da beispielsweise die beiden Hälften der Leiterplatte in identischen Verfahrensschritten hergestellt und erst am Schluss des Herstellungsverfahrens verpresst werden können. Die Dreischichtigkeit ist aber auch vorteilhaft, da die drei Schichten verschiedene Aufgaben übernehmen können. Die Substratfolien 12.1 und 12.2, die vorteilhafterweise aus Metall bestehen, übernehmen dabei die Aufgabe der mechanischen Stabilität und die Aufgabe der Wärmedissipation. Sie werden aus im Handel üblichen Folien hergestellt und nur so dick ausgelegt, dass sie ihre Aufgabe erfüllen können. Die Zwischenschicht 11 bietet Raum, wie eingangs beschrieben, um Funktionen der Infrastruktur aufzunehmen, was noch anhand von Beispielen im Zusammenhang mit den Figuren 5 bis 7 beschrieben werden soll. Selbstverständlich sind aber auch einschichtige Cores durchaus denkbar.

Die für das Core 1 verwendeten Materialien werden den jeweiligen Anforderungen und Aufgaben angepasst. Die Substratfolien können, wie in der Figur dargestellt, drei- oder mehrschichtig sein und zum Beispiel aus Kupfer/Invar/Kupfer, oder Kupfer/Molybdän/Kupfer bestehen, oder aber sie sind einschichtig und bestehen beispielsweise aus Aluminium, Molybdän/Kupfer oder einer Kohlefaserverbindung, oder sie können ganz entfallen.

Auf beiden Seiten des Cores 1, in der Figur unten und oben, liegen die aus mehreren Leiterbahnenlagen (bspw. fünf) bestehenden Schichten 2.1 und 2.2. Auf dem Core 1 liegt beispielsweise beidseitig eine Serviceebene bestehend aus zwei Leiterbahnenlagen 21 und 22. Über der Serviceebene liegen eine Erdleiterlage 23 und eine Speiseleiterlage 24, die einen Teil der Infrastruktur darstellen und gleichzeitig die Serviceebenen gegen aussen abschirmen. Die Oberfläche bildet eine Padlage 25, die als Bestückungsoberfläche dient.

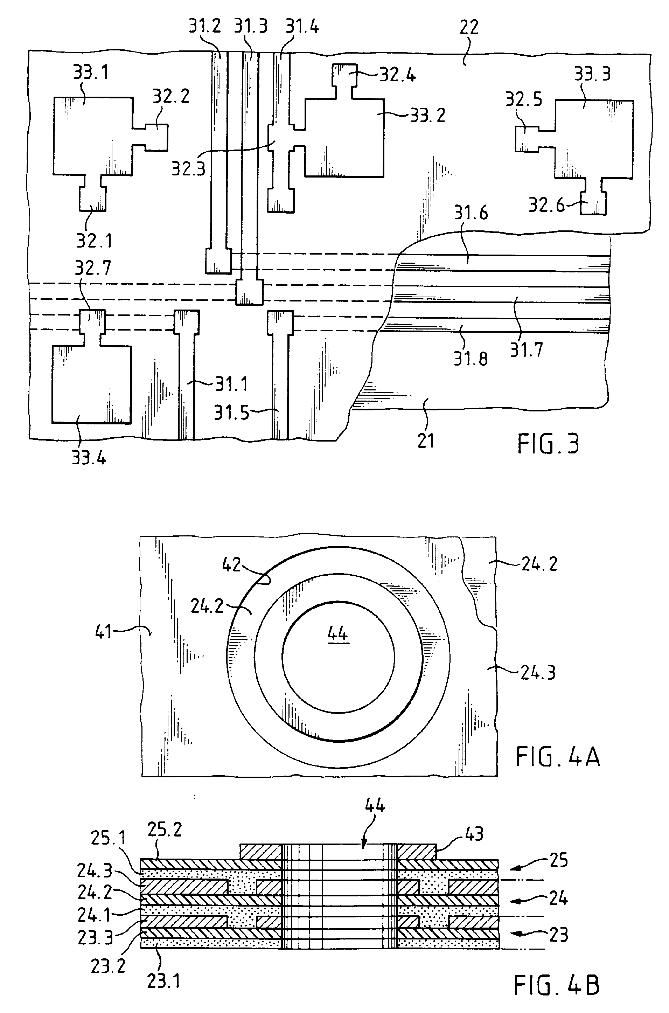

Jede einzelne der fünf Lagen 21, 22, 23, 24 und 25 setzt sich ihrerseits zusammen aus einer handelsüblichen zweischichtigen Folie bestehend aus einer Leiterschicht (z.B. 21.3), bspw. aus Kupfer, und einer isolierenden Trägerschicht (z.B. 21.2), die vorteilhafterweise aus Polyimid besteht, sowie einer darunterliegenden, ebenfalls isolierenden Verbindungsschicht (z.B. 21.1), bspw. aus Acryl-Kleber, die die Folie mit dem darunterliegenden Material verbindet. Die Verbindungsschicht kann für hohe Ansprüche auch aus Polyimid bestehen, was das Herstellungsverfahren zwar aufwendiger werden lässt, elektrische Homogenität und Temperaturbeständigkeit der Leiterplatte aber erhöht. Leiterschichten und zum Teil auch Trägerschichten und Verbindungsschichten sind dem Verwendungszweck entsprechend strukturiert, was im Zusammenhang mit den Figuren 3 und 4 noch im Detail beschrieben werden soll.

Die beiden Leiterschichten 21.3 und 22.3 der Serviceebene sind da, wo die entsprechende Schaltung es notwendig macht, kontaktiert durch entsprechende Kontaktierungen durch die Trägerschicht 22.2 (Polyimidschicht) und die Verbindungsschicht 22.1 (Acrylkleberschicht), durch überdeckte, plattierte Kontaktierungskrater innerhalb der Schicht, sogenannte "buried vias" (27.1/2/3/4). Diese Kontaktierungen beschränken sich offensichtlich auf die Schichten, die zwischen den zu kontaktierenden Schichten liegen. Die "buried vias" werden chemisch, mechanisch oder durch Laserabtrag hergestellt und haben einen Durchmesser von beispielsweise 50 bis 150»m. Im Vergleich dazu haben durchgehende Kontaktierungslöcher der herkömmlichen Multilayerplatten Durchmessern von 0,5 bis 0,9mm.

Die Leiterbahnendichte in der Serviceebene kann dank dem kleinen Durchmesser der "buried vias" derart hoch sein, dass zwei Leiterbahnenlagen für alle denkbaren Verwendungen genügen. Vom Herstellungsverfahren wie auch von der Verwendung her besteht jedoch kein zwingender Grund, die Leiterbahnenlagen der Serviceebene auf zwei zu beschränken. In der gleichen Art können drei oder mehr solche Leiterbahnenlagen übereinander gelagert und untereinander mit entsprechenden "buried vias" kontaktiert sein.

Typische Abmessungen für den Querschnitt durch die Serviceebene einer Leiterplatte, wie sie in Figur 2 dargestellt ist, wären je 25»m Dicke für die Trägerschichten 21.2 und 22.2 und die Verbindungsschichten 21.1 und 22.1, und ca. 15 bis 20»m Dicke für die Leiterschichten 21.3 und 22.3. Die "buried vias" 27 haben einen Durchmesser von 50 bis 150»m und eine Plattierungsstärke von 10 bis 15»m.

Ausserhalb der Serviceebene liegen eine Erdleiterlage 23, eine Speiseleiterlage 24 und eine Padlage 25. Diese Lagen sind gleich oder ähnlich aufgebaut wie die Lagen 21 und 22 der Serviceebene. Da die Leiterbahnen in diesen Lagen flächenartig verlaufen, und da der Raster für die Verbindungen zu den auf der Bestückungsoberfläche montierten Bauelementen durch deren Grösse gegeben ist, können diese äussersten 3 Lagen nach herkömmlichen Methoden gefertigt werden, also mit mechanisch gebohrten Kontaktierungen der einzelnen Lagen in Form von Sacklöchern 26. Die in der Figur 2 dargestellte Leiterplatte zeigt vier solche Sacklöcher 26.1/2/3/4. Die beiden Sacklöcher 26.1 und 26.2 stellen Kontaktierungen der Padlage 25 mit der äusseren Leiterbahnenlage der Serviceebene 22, das Sackloch 26.3 eine Kontaktierung mit der Erdleiterlage 23 und das Sackloch 26.4 eine Kontaktierung mit der Speiseleiterlage 24 dar.

Typische Abmessungen für den Querschnitt durch Infrastrukturebene und Padlage einer Leiterplatte, wie sie in Figur 2 abgebildet ist, wären je 25»m Dicke für die Trägerschichten 23.2, 24.2 und 25.2 und die Verbindungsschichten 23.1, 24.1 und 25.1 und bspw. 35»m für die Leiterschichten 23.3, 24.3 und 25.3. Der Durchmesser der Sacklöcher 26 ist 0,25 bis 0,45mm.

Wenn aus irgend einem Grunde auf der Leiterplattenoberfläche ein ähnlich feiner Raster gewünscht werden sollte wie auf der Serviceebene, ist es durchaus vorstellbar, Kontakte zwischen Padlage 25 und Speiseleiterlage 24, Erdleiterlage 23 oder äusserer Leiterbahnenlage 22 der Serviceebene in derselben Weise herzustellen wie die Kontaktierungen zwischen den Leiterbahnenlagen 21 und 22 der Serviceebene. Für Kontaktierungen zwischen nicht benachbarten Lagen müssen in diesem Falle entsprechend viele, jeweils um einen Rasterpunkt verschobene "buried vias" zwischen je benachbarten Lagen erstellt werden.

**Figur 3** zeigt eine Aufsicht auf eine beispielhafte Leitungsführung auf der ausgeschnittenen äusseren Leiterlage 22 und der darunterliegenden inneren Leiterlage 21 der Serviceebene. Die Leiterbahnen 31.1...8 bilden ein orthogonales Muster und sind beispielsweise 80»m breit und 80»m voneinander entfernt. Die Kontaktierungsstellen für "buried vias" 32.1...7 zu einer oberen bzw. unteren Leiterbahnenlage haben einen Querschnitt (quadratisch oder rund) mit einer Abmessung von beispielsweise 100»m. Die Kontaktierungspads 33.1...4 zu den Kontaktierungs-Sacklöchern in den aussenliegenden Leiterbahnenlagen (Erdleiterlage 23, Speiseleiterlage 24 und Padlage 25) haben Abmessungen von beispielsweise 250 bis 450»m. In der äusseren Leiterbahnenlage 22 der Serviceebene sind diese Pads unumgänglich für Sacklöcher, die für Kontaktierungen mit den Leiterbahnenlagen 23 und 24 vorgesehen sind. In der inneren Leiterbahnenlage 21 der Serviceebene werden sie nicht gebraucht. Das Rastermass des Rasters, in dem die Pads für die Kontaktierungs-Sacklöcher angeordnet sind, beträgt typisch 1,27mm und entspricht dem Raster für SMD-Bestückung. In einer bevorzugten Ausführungsform verlaufen auf der einen Leiterbahnenlage 21 alle Leiterbahnen parallel, auf der anderen Leiterbahnenlage 22 ebenfalls parallel, aber orthogonal dazu, mit Ausnahme der Pads und deren Anschlüsse.

**Figur 4A** zeigt eine Aufsicht auf eine beispielhafte Leitungsführung in der Erdleiterlage 23 oder der Speiseleiterlage 24 und darunter in Fig. 4B den entsprechenden Querschnitt durch die Leiterbahnenlagen 23, 24 und 25 für ein vorgebohrtes, aber noch nicht kontaktiertes Sackloch 44, das für eine Verbindung zwischen Padlage 25 und der äusseren Leiterbahnenlage 22 der Serviceebene vorgesehen ist. Die Erdleiterschicht 23.3 und die Speiseleiterschicht 24.3 sind als Leiterflächen 41 ausgelegt, die nur unterbrochen sind in der Gegend der Kontaktierungs-Sacklöcher, die zur Kontaktierung zwischen der Padlage 25 und der äusseren Leiterbahnenlage 22 der Serviceebene vorgesehen sind. An solchen Stellen sind die Leiterschichten für Erdung und Speisung in der aus Figur 4A ersichtlichen Art ringförmig unterbrochen. Dieselben ringförmigen Unterbrechungen 42 sind im Speiseleiter an Stellen, wo Sacklöcher eine Erdungsverbindung herstellen, und im Erdleiter an Stellen, wo Sacklöcher eine Speisungsverbindung herstellen, erforderlich.

Die Padlage 25 braucht hauptsächlich Montagepads (3 in Fig. 1) für die Bestückung, Kontaktierungspads 43 zu den Kontaktierungs-Sacklöchern und Verbindungsleiter zwischen Montagepads 3 und Kontaktierungspads 43. Die Padlage 25 ist vorteilhafterweise für SMD-Bestückung oder für TAB-Bestückung (TAB = tape automated bonding) oder für das direkte Bonden von integrierten Schaltungen mittels Golddraht ausgelegt.

Für die Herstellung der anhand der Figuren 1 bis 4 beschriebenen Leiterplatte eignen sich verschiedene Verfahren der Leiterplattenherstellung. Im Folgenden soll ein beispielhaftes Verfahren beschrieben werden. Es besteht aus den folgenden 7 Hauptverfahrensschritten:
- **A.**: Layout für alle Leiterbahnenlagen erstellen.
- **B.**: Leiterbahnenlagen 23, 24 und 25 miteinander verpressen und Kontaktierungslöcher (spätere Sacklöcher 26) bohren.
- **C.**: Core 1 bzw. Corehälften herstellen.
- **D.**: Serviceebene (Leiterbahnenlagen 21 und 22) beidseitig auf das Core 1 oder einseitig auf die Corehälften aufbringen.
- **E.**: Vorfabrikate (in Verfahrensschritt B und D hergestellt) miteinander verpressen.
- **F.**: Durchgehende Kontaktierungslöcher bohren und plattieren.
- **G.**: Oberflächen fertigstellen.

**Verfahrensschritt A:** Anwendungsspezifische Layouts müssen erstellt werden für alle Leiterbahnenlagen 21 bis 25. Die Layouts für die Padlage 25, die Speiseleiterlage 24 und die Erdleiterlage 23 sind den Layouts für gängige Multilayerplatten durchaus ähnlich und können auch auf entsprechenden CAD-Systemen erzeugt werden. Die Layouts der Leiterbahnenlagen 21 und 22 der Serviceebene unterscheiden sich durch den viel feineren Raster von den herkömmlichen Layouts, lassen sich aber mit den entsprechenden Anpassungen ebenfalls auf gängigen CAD-Systemen herstellen.

**Verfahrensschritt B:** Die äussersten drei Leiterbahnenlagen, d.h. die Erdleiterlage 23, die Speiseleiterlage 24 und die Padlage 25 werden in den folgenden Schritten vorbereitet und zu einem Vorfabrikat verpresst. Alle Teilschritte sind aus der gängigen Leiterplattentechnik zur Herstellung von Multilayerplatten bekannt.
- **B.1**: Die Layouts für die Erdleiterlage und die Speiseleiterlage werden mit bekannten photochemischen Methoden auf Folien, bestehend aus einer Leiterschicht, bspw. Kupfer, und einer Trägerschicht, bspw. Polyimid, übertragen. Für diese Leiterbahnenlagen lassen sich aber auch die üblicheren dreischichtigen Folien verwenden, die zwischen der Leiterschicht und der Trägerschicht noch eine Verbindungsschicht enthalten.
- **B.2**: Die Leiterschichten werden mit bekannten Methoden geätzt.
- **B.3**: Die beiden Folien für die Erdleiterlage 23 und die Speiseleiterlage 24 werden mit einer noch unstrukturierten, gleichartigen Folie für die Padlage 25 mit zwei Verbindungsschichten, bspw. mit Acryl-Kleber, verpresst.
- **B.4**: Die Kontaktierungslöcher (Sacklöcher 26) werden im Mehrfachstapel gebohrt (Lochdurchmesser 250 bis 400»m).

**Verfahrensschritt C:** Die Herstellung des Cores 1 hängt sehr vom verwendeten Material und von den Aufgaben ab, die vom Core noch übernommen werden sollen (weitere Herstellungshinweise werden auch noch im Zusammenhang mit den entsprechenden Figuren 5 bis 7 gegeben). Soll das Core aus mehreren Folien bestehen und sollen in entsprechenden Aussparungen Bauelemente wie zum Beispiel Chipkondensatoren oder Pull-up-Widerstände untergebracht werden, werden bedeutend mehr Verfahrensschritte notwendig sein, als im Falle eines ein- bis dreischichtigen Cores, das nur der Wärmeableitung dient. In vielen Fällen erweist es sich als vorteilhaft, das Core in dieser Verfahrensstufe als zwei Corehälften herzustellen, die dann erst in einem späteren Verfahrensschritt (E) miteinander verpresst werden. Alle Teilschritte der Coreherstellung sind aus der gängigen Leiterplattentechnik bekannt.

**Verfahrensschritt D:** In diesem Verfahrensschritt werden die Leiterbahnenlagen 21 und 22 der Serviceebene auf dem Core aufgebracht und die Kontaktierungen zwischen diesen Lagen hergestellt. Die Teilschritte sind die Folgenden:
- **D.1**: Die Folie für die innere Leiterbahnenlage 21 wird mit einer Verbindungsschicht 21.1 aus bspw. Acryl- oder Epoxyd-Kleber mit dem Core verpresst. In den beschriebenen Beispielen von Leiterplatten werden Folien verwendet, die aus einer Leiterschicht 21.3, z.B. Kupfer, und einer Trägerschicht 21.2, z.B. Polyimid, bestehen.
- **D.2**: Mit bekannten photochemischen Methoden wird das Layout der inneren Leiterbahnenlage 21 der Serviceebene auf die Leiterschicht 21.3 übertragen und diese zur anwendungsspezifischen Struktur geätzt. Wegen des feinen Rasters dieser Leiterbahnenlagen wird vorteilhafterweise ein flüssiger Photolack verwendet.
- **D.3**: Die Folie für die äussere Leiterbahnenlage 22 der Serviceebene wird mit einer Verbindungsschicht 22.1 auf die strukturierte Leiterschicht 21.3 aufgepresst.
- **D.4**: Die Struktur der zu erstellenden "buried vias" 27 wird auf photochemischem Weg auf die Leiterschicht 22.3 übertragen, letztere mit chemischen Methoden an den Stellen der Löcher entfernt und anschliessend durch geeignete Methoden wie Ätzen oder Laserabtrag die Trägerschicht 22.2 und die Verbindungsschicht 22.1 entfernt.
- **D.5**: Die "buried vias" werden durchplattiert (Plattierung 10 bis 15»m dick) und damit die Leiterschichten 21.3 und 22.3 elektrisch verbunden.
- **D.6**: Das Layout der äusseren Leiterbahnenlage 22 der Serviceebenen wird in derselben Art und Weise wie bei der inneren Leiterbahnenlage 21 übertragen und die Leiterschicht 22.3 geätzt (vergleiche Teilschritt D.2).

**Verfahrensschritt E:** Das im Verfahrensschritt B hergestellte Vorfabrikat, bestehend aus den drei äusseren Leiterbahnenlagen 23, 24 und 25 wird in diesem Verfahrensschritt mit dem Core und der Serviceebene verpresst und, für den Fall, dass das Core als zwei Corehälften hergestellt wurde, werden auch diese beiden Hälften verpresst. Die entsprechenden Teilschritte sind aus Herstellungsverfahren für Multilayerplatten bekannt.

**Verfahrensschritt F:** Die Leiterplatte wird fertiggestellt, das heisst, die notwendigen, durchgehenden Löcher werden gebohrt, rückgeätzt und durchplattiert. Dann wird zum Beispiel mit Trokkenfilmlaminattechnik das Layout auf die Padlage 25 übertragen und diese geätzt, die Pads werden dann vergoldet, die Vergoldung abgedeckt und die Oberfläche Heissluft-verzinnt. Die Plattenkanten werden geschnitten und metallisiert. Alle diese Teilschritte sind aus den Herstellungsverfahren für Multilayerplatten bekannt. Das mit den sieben Schritten A bis F beschriebene, beispielhafte Verfahren lässt sich in den wesentlichen Schritten B bis E variieren. Drei Varianten sind nachstehend angegeben. Weitere Abwandlungen sind dem Fachmann in Kenntnis dieser Vorgänge leicht möglich.

Variante 1: Durch Wiederholung der Schritte D.3 bis D.6 ergibt sich eine mehr als zweilagige Serviceebene, wobei die Verbindungen stufenweise von Lage zu Lage erfolgen.

Variante 2: Die äusseren Leiterbahnenlagen werden nicht als Vorfabrikat hergestellt, sondern lagenweise auf der Serviceebene aufgebracht. d.h. die Schritte D.3 bis D.6 werden für die Lagen 23, 24 und 25 wiederholt. Auch hier wird dann also die gewünschte Kontaktierung für jede Lage durch "buried vias" von Lage zu Lage realisiert. Dadurch entfallen die Schritte B und E.

Variante 3: Die Serviceebene wird ebenfalls als Vorfabrikat hergestellt. Dabei wird mit einer kaschierten Einzelfolie als Leiterbahnenlage 21 gleichsam als Schritt D.1′ gestartet und darauf werden die Schritte D.2 ff angewendet. Nebst den Schritten B und C verläuft jetzt also auch der Schritt D parallel, wobei der Teilschritt D.1 unmittelbar vor Schritt E nachgeholt wird.

Schliesslich besteht eine weitere Verfahrensvariante bezüglich Herstellung der Schichtung der einzelnen Leiterbahnenlagen darin, als Verbindungsschicht 22.1 und eventuell auch 21.1 anstelle eines Klebers flüssiges Polyimid oder noch nicht polymerisierte Polyimidfolie zu verwenden. Da das dabei verwendete Polyimid ausgehärtet werden muss, bringt dies einen anders gearteten Verfahrensschritt mit sich. Die Wärmeausdehnung einer derart hergestellten Platte ist insbesondere in Richtung der Plattendicke geringer und es wird eine höhere Dauertemperaturbelastung möglich.

Zwischen den einzelnen Teilschritten des erfindungsgemässen Herstellungsverfahrens müssen selbstverständlich an den verschiedensten Orten Kontroll- und Prüfschritte eingefügt werden, die in der obigen Aufzählung der Schritte nicht enthalten sind. Solche Kontroll- und Prüfschritte unterscheiden sich nicht prinzipiell von entsprechenden Schritten aus anderen Leiterplattenherstellverfahren und können dem Fachmann zur Auslegung überlassen werden.

**Figur 5** zeigt eine Leiterplatte gemäss der bisherigen Beschreibung, in deren Core 1 in der Zwischenschicht 11 ein Kondensator integriert ist. Der Kondensator ist aus aufeinandergepressten, aus einer Leiter- und einer Isolationsschicht bestehenden Folien hergestellt. Die Leiterschichten sind abwechslungsweise mit verschiedenen, durchgehenden Kontaktierungslöchern 6 kontaktiert. Die Leiterschichten 51.1 bis 51.6 sind beispielsweise über das Kontaktierungsloch 6.1 mit dem Erdleiter der Leiterplatte, die Leiterschichten 52.1 bis 52.6 über das Kontaktierungsloch 6.2 mit dem Speiseleiter der Leiterplatte kontaktiert. Da sich die Zwischenschicht 11 und dadurch auch die Leiterschichten 51 und 52 über grössere Teile der Leiterplatte erstrecken können (nur wenige bestückungsabhängige, durchgehende Löcher), kann ein derart integrierter Folienkondensator eine Kapazität im Mikrofarad-Bereich aufweisen und somit als Pufferkondensator beschaltet werden. Damit wird auf der Bestükungsoberfläche der Raum für einen entsprechenden Kondensator, der nach dem Stande der Technik bis zu 20% der Leiterplattenoberfläche betragen kann, für andere Bestückungselemente frei.

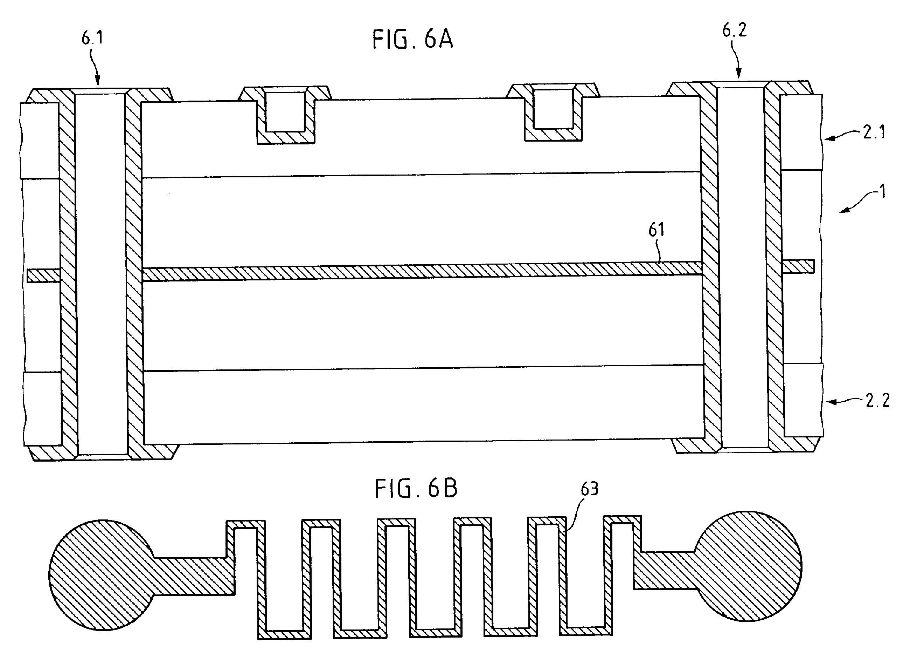

**Figur 6A** zeigt schematisiert ebenfalls die bekannte Leiterplatte gemäss der bisherigen Beschreibung. In deren Core 1, genauer in der Zwischenschicht 11, ist beispielhaft eine Lage 61 gezeigt, die beim Verpressen des Cores 1 bzw. der beiden Corehälften in bekannter Weise eingebracht wird, wie dies in der Beschreibung der Verfahrensschritte C bzw. E angegeben ist. Die Lage selbst enthält eine im Handel erhältliche Widerstandsfolie, aus der z.B. Mäander-Widerstände herausgeätzt wurden, wie dies für einen Widerstand 63 aus der **Figur 6B** ersichtlich ist. Selbstverständlich können in ein Core 1 mehrere solcher Lagen 61 mit Widerständen 63 eingebracht werden. Die Kontaktierung erfolgt in bekannter Weise über durchplattierte Löcher 6.1 und 6.2, die ihrerseits in den Leiterbahnenlagen der Schichten 2.1 und/oder 2.2 Verbindung haben. Die Schichtwiderstände 63 können z.B. als Pull-up-Widerstände dienen.

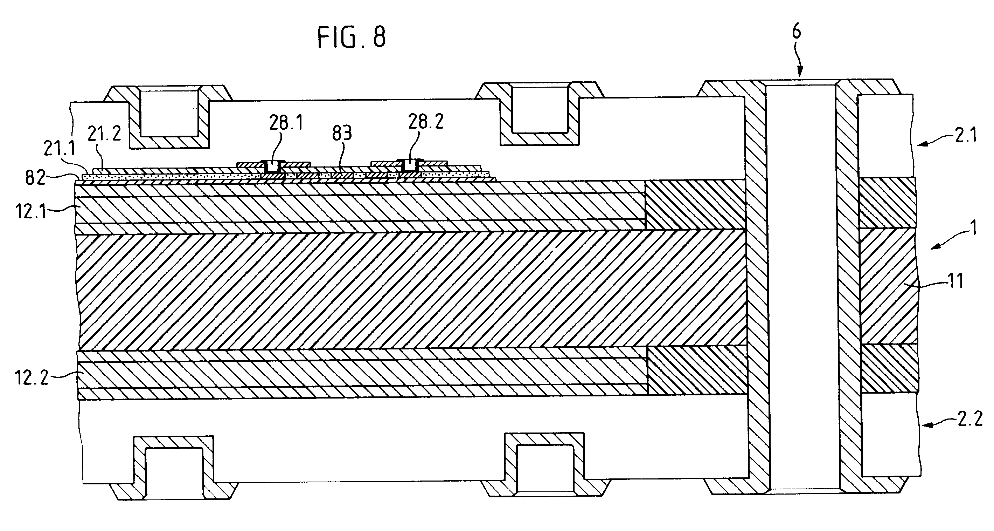

Eine weitere Möglichkeit, Widerstände zu integrieren, ist im Zusammenhang mit der Figur 8 angegeben.

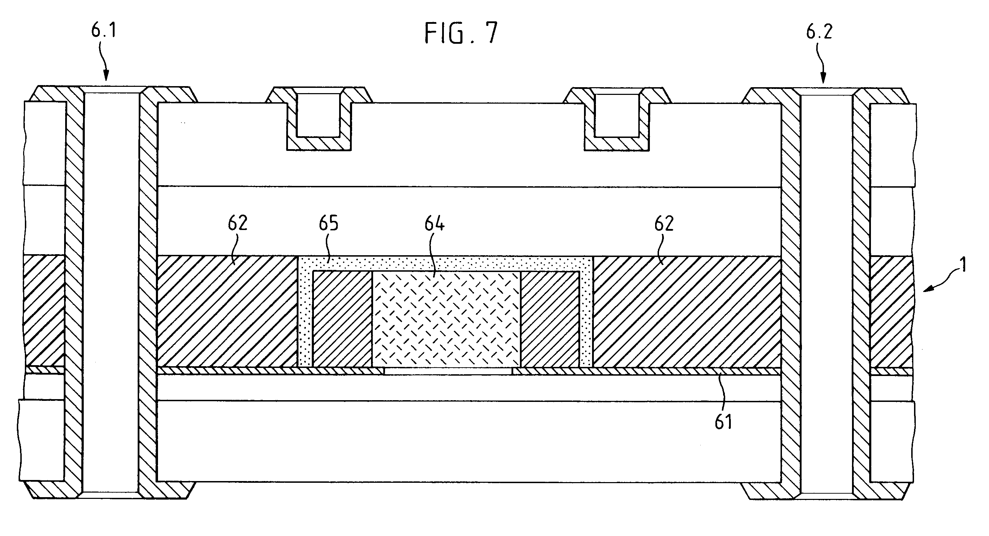

**Figur 7** zeigt ein weiteres Beispiel für die Ausnützung des im Core vorhandenen Platzes. Auf der Leiterbahnenlage 61 im Core 1 bzw. dessen Zwischenschicht 11 ist ein Bauteil 64, z.B. ein Chip-Kondensator, aufgelötet oder elektrisch leitend aufgeklebt. Die Cu-Schicht der Leiterbahnenlage 61, eines Basismaterials für die Leiterplattenherstellung, wird in bekannter Weise durch Ätzen strukturiert und die ganze Lage entweder direkt auf der Innenseite des Substrates (nicht mehr gezeichnet) oder auf einer Schicht der Kunststoffüllung (Zwischenschicht 11) angebracht. In weiteren Herstellungsschritten wird ein Teil der Kunststoffüllung 62 etwa in der Stärke des Bauteiles separat vorbereitet, mit Fenstern versehen und aufgebracht, danach werden die Bauteile mit ihren Anschlussstellen in den Aussparungen auf die Cu-Schicht geklebt bzw. mit ihr verlötet und die Hohlräume durch eine Kunststoffverkapselung 65 aufgefüllt.

**Figur 8** zeigt einen Gesamtaufbau, gemäss welchem vor dem Aufbringen der Leiterlagen 21 und 22 der Serviceebene auf die Substratfolie 12.1 bzw. 12.2 eine Isolationsschicht 82 und darauf Dünnschichtwiderstände 83 aufgebracht werden und dass zur Kontaktierung dieser Dünnschichtwiderstände 83 in der inneren Leiterbahnenlage 21 der Serviceebene "buried vias" 28 erstellt werden. Dies kann einseitig oder beidseitig vorgesehen sein, wobei jedesmal der Kern 1 normschichtdickenkompensierend ausgestaltet ist. Zur Herstellung dieses Gesamtaufbaues werden auf der Aussenseite der Substratfolie 12.1 bzw.12.2 eine zusätzliche, emaillierte Isolationsschicht 82 und darauf präzise Widerstände in Dünnfilmtechnik aufgebracht. Diese Dünnschichtwiderstände lassen sich durch "buried vias" 28 in der inneren Leiterbahnenlage 21 der Serviceebene, die unter analoger Anwendung der unter D.3 bis D.5 für die Lage 22 beschriebenen Verfahrensschritte auf die Lage 21 hergestellt werden, mit der Lage 21 kontaktieren. Da beim Verpressen der Leiterbahnfolien keine, die Präzision der Widerstände beeinträchtigende Temperaturen angewendet werden müssen, ist es möglich, die Dünnschichtwiderstände 83 abgedeckt im Innern der Leiterplatte zu haben. Durch den unmittelbaren Kontakt mit dem gut wärmeleitenden Substrat 12.1 sind die Temperaturschwankungen an den Widerständen gering.

Selbstverständlich können die im Zusammenhang mit den Figuren 5 bis 8 beschriebenen Merkmale auch gemeinsam auf der gleichen Leiterplatte realisiert sein.

Somit zeichnet sich gesamthaft gesehen das Verfahren zur Herstellung von mehrschichtigen Leiterplatten durch folgende Verfahrensschritte aus: In vorbereitenden Verfahrensschritten wird die Gesamtfunktion des Multilayers zerlegt in Funktionen, die mit einem Grobraster realisiert werden sollen, das sind zum Beispiel die Leitungen für die Speisung und die Masse oder Massenflächen und so weiter, und in Funktionen, die mit einem Feinraster realisiert werden sollen, das sind zum Beispiel Signalleitungen. Die Grob- und Feinrasterfunktionen werden je einem Layoutprozess zugewiesen und in je einem Herstellungsprozess, vorzugsweise auf Folien, getrennt realisiert. Die entstandenen folienförmigen Teilfabrikate werden falls erwünscht auch getrennt getestet und dann zusammenlaminiert und als Zwischenfabrikat für die Fertigstellung von mehrschichtigen Leiterplatten bereitgehalten. Der Vorteil dieses Vorgehens liegt darin, dass durch die Entmischung (Entflechtung) der Grob- und Feinrasterfunktionen konsequent dichte Leiterbahnebenen, die als superfeine Service-Ebenen dienen, hergestellt werden können, dies bis an die Grenzen der Realisierungsmöglichkeiten, und die Grobrasterfunktionen in einer Schicht für sich angewendet werden kann. Dies lässt eine Optimierung der Erdleiterflächen zu, sodass diese Grobrasterschichten unter anderem als 50Ω-Abschirmung eingesetzt werden können. Auf diese Weise entsteht ein Zwischenfabrikat, das eine sehr hohe innere Dichte (Feinraster) aufweist und als 50Ω-Layer in Multilayers "eingezogen" werden kann. Die Anschlüsse, bspw. in Grobrasterabstand, können peripher oder extern angelegt werden. Diese Zwischenfabrikate werden zur Herstellung von mehrschichtigen Leiterplatten in einem Verfahrensabschnitt als ein erstes Vorfabrikat hergestellt, nämlich Schichten 2.1,2.2 bestehend aus Folien für Leiterbahnenlagen mit Service- 21,22 und Versorgungsebenen 23,24. In einem anderen Verfahrensabschnitt, der parallel zum vorigen Verfahrensabschnitt laufen kann, wird ein zweites Vorfabrikat hergestellt, nämlich Leiterplattenkerne 1 mit einer Normkompensationsschichtdicke, das ist das Schichtdickenmass einer Leiterplatten-Normschichtdicke minus die Schichtdicke aufzubringender Schichten von Leiterbahnenlagen des ersten Vorfabrikats nach Aufpressen auf einen Kern. Die verwendete Filmtechnik ergibt relativ grosse Normkompensationsschichtdicken, das heisst, dass die Kernschicht wesentlich dicker ist, als in üblichen Beschichtungsverfahren. Diese Kerndicke lässt sich, wie schon beschrieben, speziell ausnützen. In einem Vereinigungs-Verfahrensschritt, der die Verfahrensabschnitte zur Herstellung der Vorfabrikate miteinschliessen kann, das heisst, dass solche Verfahrensabschnitte gleichzeitig ablaufen können, werden die ersten und zweiten Vorfabrikate zu an ihrer Oberfläche 25 leiterbahnenstrukturierbaren und durchleitungsbohrbaren Halbfabrikaten zusammengepresst. Diese Halbfabrikate sind layoutfähige Leiterplatten mit einem komplexen, schaltungsvorbereiteten Innendasein, welches sich, ähnlich wie bei Universalschaltungsplatten, in viele Layouts mit einbeziehen lässt.

In Abwandlung der obigen Verfahrensabschnitte wird in einem Verfahrensabschnitt ein erstes Vorfabrikat hergestellt, nämlich Schichten 2.1,2.2 bestehend aus Folien für Leiterbahnenlagen mit Versorgungsebenen 23,24, wobei in einem anderen Verfahrensabschnitt ein zweites Vorfabrikat hergestellt wird, nämlich Leiterplattenkerne 1 mit aufgezogener Serviceebene 21,22 mit einer Normkompensationsschichtdicke, das ist hier das Schichtdickenmass einer Leiterplatten-Normschichtdicke minus die Schichtdicke aufzubringender Schichten von Leiterbahnenlagen des ersten Vorfabrikats, also der Versorgungsebenen 23,24. In einem Vereinigungs-Verfahrensschritt, der die Verfahrensabschnitte zur Herstellung der Vorfabrikate miteinschliessen kann, werden erste und zweite Vorfabrikate zu an ihrer Oberfläche 25 leiterbahnenstrukturierbaren und durchleitungsbohrbaren Halbfabrikaten zusammengepresst.

In einem weiteren Verfahrensschritt werden die Halbfabrikate an der oder den Aussenflächen 25 für Leiterbahnen mit Leiterbahnen versehen und mit Leiterbahnen aus den Service- 21,22 und Versorgungsebenen 23,24 verbunden. Das ist dann nicht mehr ein Halbfabrikat, sondern eine fertige Leiterplatte, die anschliessend bestückt werden kann.

Eine nach dem diskutierten Verfahren hergestellte Leiterplatte besteht aus einer die Normschichtdicke kompensierenden Kernschicht 1 mit ein- oder beidseitig darauf angebrachten Schichten 2.1 und 2.2 mit Leiterbahnenlagen 21 bis 25, die aus gepressten Folien gebildet sind und weist eine Normschichtdicke auf. Die Kernschicht weist soviel Platz auf, dass darin oder in ihrem nächsten Bereich elektrische, mechanische oder thermische Elemente untergebracht werden können. So kann eine Zwischenschicht 11 des Kerns 1 beispielsweise mit als Pull-up-Widerstände beschalteten Folienwiderstände 63 oder als Koppelkapazitäten beschaltete Chipkondensatoren 64 oder als Pufferkapazitäten beschaltete Folienkondensatoren 51/52 bestückt sein.

Der Kern 1 kann aus zwei Kernhälften hergestellt werden, wobei auf der dem Kerninnern zugewandten Seite der einen Kernhälfte vor dem Verpressen eine Leiterbahnenlage 61 erstellt und mit Bauteilen 64 bestückt wird, wobei dann die beiden Kernhälften mit einer der Bestückung entsprechend strukturierten Kunststoffüllschicht dazwischen verpresst werden.

Dies alles zeigt, wie universell eine Leiterplatte gemäss dem erfinderischen Vorgehen ausgestaltet werden kann, dies immer mit dem gleichen Grundvorgehen, und wie deren Bestückung sich sehr gut automatisieren lässt (automated tape bonding). Damit sind hochkomplexe Leiterplatten herstellbar, die der stets zunehmenden Bauteildichte noch lange gerecht werden können.

## Patentansprüche

1. Verfahren zur Herstellung von mehrschichtigen Leiterplatten durch Zusammenpressen von mindestens zwei Zwischenfabrikaten mit Leiterbahnenlagen, **dadurch gekennzeichnet,** dass die Schaltung der Leiterplatte in eine Teilschaltung für einen Grobraster und eine Teilschaltung für einen Feinraster aufgeteilt wird, dass die Grobraster- und die Feinrasterschaltung getrennt als je eine oder mehrere Leiterbahnenlagen ausgelegt werden, dass mindestens ein Teil der Leiterbahnenlagen der Grobrasterschaltung (23, 24, 25) auf Leiterschichten-tragenden Folien realisiert und zu einem ersten Zwischfabrikat vereinigt werden und dass mindestens ein erstes Zwischenfabrikat mit mindestens einem weiteren Zwischenfabrikat, das die Feinrasterschaltung und einen die Leiterplatte zu einer gewünschten Gesamtdicke ergänzenden Kern umfasst, vereinigt wird, derart, dass die Feinrasterschaltung zwischen Grobrasterschaltung und Kern angeordnet ist.

2. Verfahren nach Anspruch 1, **dadurch gekennzeichnet,** dass der Grobraster den Kontaktabständen von Bestückungselementen entspricht und dass der Feinraster ein beliebiger, von Kontaktabständen unabhängiger Leiterbahnenraster ist.

3. Verfahren nach Anspruch 1 oder 2, **dadurch gekennzeichnet,** dass das Rastermass des Grobrasters 1,27mm, das Rastermass des Feinrasters 160»m beträgt.

4. Verfahren nach einem der Ansprüche 1 bis 3, **dadurch gekennzeichnet,** dass das erste Zwischenfabrikat durch Zusammenpressen von mehreren Leiterschichten-tragenden Folien hergestellt wird, wobei die Leiterschichten der innenliegenden Leiterbahnenlagen (23, 24) vorgängig strukturiert werden, die Leiterschicht der äusseren Leiterbahnenlage (25) erst nach dem Zusammenpressen der Zwischenfabrikate.

5. Verfahren nach einem der Ansprüche 1 bis 4, **dadurch gekennzeichnet,** dass das erste Zwischenfabrikat mit durchgehenden Kontaktierungslöchern versehen wird, die nach dem Zusammenpressen der Zwischenfabrikate als Sacklöcher (26) plattiert werden.

6. Verfahren nach einem der Ansprüche 1 bis 5, **dadurch gekennzeichnet,** dass zur Herstellung des weiteren Zwischenfabrikats die Leiterbahnenlagen (21 und 22) der Feinrasterschaltung eine nach der anderen durch Aufpressen je einer Folie auf eine Kernschicht oder den Kern (1) oder auf eine bereits aufgepresste Leiterbahnenlage, durch nachfolgendes Erstellen von "buried vias" (27) als Kontaktierungen zur darunterliegenden Leiterbahnenlage oder zur Kernschicht und schliesslich durch photochemisches Übertragen des Layouts und Ätzen der Leiterschicht erstellt werden.

7. Verfahren nach einem der Ansprüche 1 bis 5, **dadurch gekennzeichnet,** dass zur Herstellung des weiteren Zwischenfabrikates die Leiterbahnenlagen (21 und 22) der Feinrasterschaltung auf einer doppeltkaschierten Einzelfolie realisiert werden und dass die strukturierte Folie mit einer Kernschicht oder dem Kern (1) verpresst wird.

8. Verfahren nach einem der Ansprüche 1 bis 7, **dadurch gekennzeichnet,** dass für die Herstellung der Leiterbahnenlagen der Feinrasterschaltung und der Leiterbahnenlagen der Grobrasterschaltung zweischichtige Folien, die aus einer Leiterschicht (z.B 21.3) und einer Trägerschicht (z.B. 21.2) bestehen, oder dreischichtige Folien, die zwischen der Leiterschicht und der Trägerschicht noch eine Bindeschicht enthalten, verwendet werden und dass diese Folien mit einer Verbindungsschicht (z.B. 21.1) miteinander verpresst werden.

9. Verfahren nach einem der Ansprüche 1 bis 8, **dadurch gekennzeichnet,** dass der Kern (1) durch Verpressen von mindestens drei Schichten, einer Zwischenschicht (11) und zwei Substratfolien (12.1 und 12.2), hergestellt wird.

10. Verfahren nach einem der Ansprüche 1 bis 8, **dadurch gekennzeichnet,** dass der Kern (1) durch Verpressen von zwei Kernhälften hergestellt wird, wobei vor dem Verpressen auf der dem Kerninnern zugewandten Seite der einen Kernhälfte eine Widerstandsfolie (61) aufgepresst und strukturiert wird.

11. Verfahren nach Anspruch 10, **dadurch gekennzeichnet,** dass zwischen den beiden Kernhälften mindestens eine zusätzliche Kunststoffüllschicht mit aufgepresster, strukturierter Widerstandsfolie verpresst wird.

12. Verfahren nach einem der Ansprüche 1 bis 11, **dadurch gekennzeichnet,** dass der Kern (1) als zwei Kernhälften hergestellt wird, wobei auf der dem Kerninnern zugewandten Seite der einen Kernhälfte vor dem Verpressen eine Leiterbahnenlage (61) erstellt und mit Bauteilen (64) bestückt wird, und dass die beiden Kernhälften mit einer der Bestückung entsprechend strukturierten Kunststoffüllschicht dazwischen verpresst werden.

13. Verfahren nach einem der Ansprüche 1 bis 12, **dadurch gekennzeichnet,** dass vor dem Aufbringen der Leiterlagen (21 und 22) der Feinrasterschaltung auf die Kernschicht (12.1 rsp. 12.2) eine Isolationsschicht (82) und darauf Dünnschichtwiderstände (83) aufgebracht werden und dass zur Kontaktierung dieser Dünnschichtwiderstände (83) in der inneren Leiterbahnenlage (21) der Feinrasterschaltung "buried vias" (28) erstellt werden.

14. Mehrschichtige Leiterplatte hergestellt nach dem Verfahren gemäss Ansprüchen 1 bis 13, **dadurch gekennzeichnet,** dass sie eine Teilschaltung mit einem Grobraster und eine Teilschaltung mit einem Feinraster aufweist, dass die Grobraster- und die Feinrasterschaltung in je einer oder mehreren Leiterbahnenlagen angeordnet sind und dass die Feinrasterschaltung zwischen der Grobrasterschaltung und einem die Leiterplatte zu einer gewünschten Gesamtdicke ergänzenden Kern (1) angeordnet ist.

15. Leiterplatte nach Anspruch 14, **dadurch gekennzeichnet,** dass der Raster der äusseren Leiterbahnenlagen (23, 24 und 25) den Kontaktabständen von Bestückungselementen entspricht, der Raster der inneren Leiterbahnenlagen (21 und 22) aber feiner ist.

16. Leiterplatte nach einem der Ansprüche 14 oder 15, **dadurch gekennzeichnet,** dass das Rastermass der Grobrasterschaltung 1,27mm, das Rastermass der Feinrasterschaltung 160»m beträgt.

17. Leiterplatte nach einem der Ansprüche 14 bis 16, **dadurch gekennzeichnet,** dass sie auf den Bestückungsoberflächen Sacklöcher (26) aufweist, die die äusseren Leiterbahnenlagen (23, 24 und 25) durchdringen und auf der äussersten Leiterbahnlage (22) der Feinrasterschaltung enden.

18. Leiterplatte nach einem der Ansprüche 14 bis 17, **dadurch gekennzeichnet,** dass zwischen den Leiterbahnenlagen (21 und 22) der Feinrasterschaltung "buried vias" (27) vorhanden sind.

19. Leiterplatte nach einem der Ansprüche 14 bis 18, **dadurch gekennzeichnet,** dass bei beidseitigen Leiterbahnenschichten (2.1 und 2.2) der Kern (1) die Hälfte bis einen Drittel des Gesamtvolumens der unbestückten Leiterplatte, bei einseitiger Leiterbahnenschicht (nur 2.1) drei Viertel bis zwei Drittel dieses Volumens beträgt.

20. Leiterplatte nach einem der Ansprüche 14 bis 19 **gekennzeichnet durch** einen Kern (1), der elektrische, mechanische oder thermische Elemente aufweist, die auf der Oberfläche des Kerns oder in seinem Innern angeordnet sind.

21. Leiterplatte nach Anspruch 20, **dadurch gekennzeichnet,** dass sie in einer Zwischenschicht (11) des Kerns (1) als Pull-up-Widerstände beschaltete Dünnschichtwiderstände (63) aufweist.

22. Leiterplatte nach Anspruch 20, **dadurch gekennzeichnet,** dass sie in der Zwischenschicht (11) des Kerns (1) als Chipkondensatoren beschaltete Kondensatoren (64) aufweist.

23. Leiterplatte nach Anspruch 20, **dadurch gekennzeichnet,** dass sie in der Zwischenschicht (11) des Kerns (1) als Pufferkondensatoren beschaltete Folienkondensatoren (51/52) aufweist.

24. Leiterplatte nach einem der Ansprüche 20 bis 23, **dadurch gekennzeichnet,** dass der Kern (1) zwei Kernhälften aufweist, wobei auf der dem Kerninnern zugewandten Seite der einen Kernhälfte eine mit Bauteilen (64) bestückte Leiterbahnenlage (61) angeordnet ist, und dass zwischen den beiden Kernhälften eine der Bestückung entsprechend strukturierte Kunststoffüllschicht vorgesehen ist.

25. Leiterplatte nach einem der Ansprüche 20 bis 24, **dadurch gekennzeichnet,** dass sie als äusserste Schicht des Kerns (1) unter der innersten aus verpressten Folien bestehenden Leiterbahnenlage (21) der Feinrasterschaltung Dünnschichtwiderstände (83) aufweist, die mittels "buried vias" (28) mit der Leiterbahnenlage (21) kontaktiert sind.

## Claims

1. Process for the production of multilayer printed circuit boards by pressing together at least two intermediates with conductor layers, characterized in that the circuit for the circuit board is subdivided into a partial circuit for a coarse grid and a partial circuit for a fine grid, that the coarse and fine grid circuits are separately designed as in each case one or more conductor layers, that at least one part of the conductor layers of the coarse grid circuit (23,24,25) is implemented on conductor coating-carrying foils and combined to form a first intermediate and that at least one first intermediate is joined to at least one further intermediate, which comprises the fine grid circuit and a core supplementing the circuit board to give a desired overall thickness, in such a way that the fine grid circuit is positioned between the coarse grid circuit and the core.

2. Process according to claim 1, characterized in that the coarse grid corresponds to the contact spacings of insertion elements and that the fine grid is a random conductor grid independent of the contact spacings.

3. Process according to claim 1 or 2, characterized in that the coarse grid size is 1.27 mm and the fine grid size 160 »m.

4. Process according to one of the claims 1 to 3, characterized in that the first intermediate is produced by pressing together several conductor coating-carrying foils, the conductor coatings of the inner conductor layers (23,24) being structured beforehand and the conductor coating of the outer conductor layer (25) only following the pressing together of the intermediates.

5. Process according to one of the claims 1 to 4, characterized in that the first intermediate is provided with through contacting holes, which following the pressing together of the intermediates are plated as blind holes (26).

6. Process according to one of the claims 1 to 5, characterized in that for the production of the further intermediate the conductor layers (21,22) of the fine grid circuit are successively produced by in each case pressing one foil on a core layer or the core (1) or on an already pressed conductor layer, by the subsequent production of buried vias (27) as contacting points to the underlying conductor layer or to the core layer and finally by photochemical transfer of the layout and etching the conductor coating.

7. Process according to one of the claims 1 to 5, characterized in that for the production of the further intermediate the conductor layers (21,22) of the fine grid circuit are implemented on a double-clad single foil and that the structured foil is bonded to a core layer or the core (1).

8. Process according to one of the claims 1 to 7, characterized in that for the production of the conductor layers of the fine grid circuit and the conductor layers of the coarse grid circuit two layer foils formed from a conductor coating (e.g. 21.3) and a carrier coating (e.g. 21.2), or three layer foils having between the conductor coating and the carrier coating a binding coating are used and that these foils are pressed together with a connecting coating (e.g. 21.1).

9. Process according to one of the claims 1 to 8, characterized in that the core (1) is produced by bonding at least three coatings, an intermediate coating (11) and two substrate foils (12.1,12.2).

10. Process according to one of the claims 1 to 8, characterized in that the core (1) is produced by bonding two core halves and prior to the bonding onto the side of one core half facing the core interior is pressed and structured a resistance film (61).

11. Process according to claim 10, characterized in that between the two core halves is bonded at least one additional plastic filling coating with a pressed-on, structured resistance film.

12. Process according to one of the claims 1 to 11, characterized in that the core (1) is produced from two core halves and on the side of one core half facing the core interior is produced, prior to bonding, a conductor layer (61) which is loaded with components (64) and that the two core halves are bonded with an intermediate plastic filling layer structured in accordance with the loading.

13. Process according to one of the claims 1 to 12, characterized in that prior to the application of the conductor layers (21,22) of the fine grid circuit to the core layer (12.1,12.2) an insulating layer (82) and on the latter thin-film resistors (83) are applied and that for contacting said thin-film resistors (83) buried vias (28) are produced in the inner conductor layer (21) of the fine grid circuit.

14. Multilayer printed circuit board produced according to the process of claims 1 to 13, characterized in that it has a partial circuit with a coarse grid and a partial circuit with a fine grid, that the coarse and fine grid circuits are in each case arranged in one or more conductor layers and that the fine grid circuit is positioned between the coarse grid circuit and a core (1) supplementing the circuit board to a desired overall thickness.

15. Printed circuit board according to claim 14, characterized in that the grid of the outer conductor layers (23,24,25) corresponds to the contact spacings of insertion elements, but the grid of the inner conductor layers (21,22) is finer.

16. Printed circuit board according to one of the claims 14 or 15, characterized in that the grid size of the coarse grid circuit is 1.27 mm and the grid size of the fine grid circuit 160 »m.

17. Printed circuit board according to one of the claims 14 to 16, characterized in that on the insertion surfaces it has blind holes (26), which penetrate the outer conductor layers (23,24,25) and end at the outermost conductor layer (22) of the fine grid circuit.

18. Printed circuit board according to one of the claims 14 to 17, characterized in that there are buried vias (27) between the conductor layers (21,22) of the fine grid circuit.

19. Printed circuit board according to one of the claims 14 to 18, characterized in that in the case of two-sided conductor coatings (2.1 and 2.2), the core (1) represents 1/2 to a 1/3 of the total volume of the unloaded circuit board and with a one-sided conductor coating (only 2.1) it represents 3/4 to 2/3 of said volume.

20. Printed circuit board according to one of the claims 14 to 19, characterized by a core (1), which has electrical, mechanical or thermal elements, which are located on the surface of the core or in its interior.

21. Printed circuit board according to claim 20, characterized in that it has in an intermediate layer (11) of the core (1) thin-film resistors (63) wired as pull-up resistors.

22. Printed circuit board according to claim 20, characterized in that it has in the intermediate layer (11) of the core (1) capacitors (64) wired as chip capacitors.

23. Printed circuit board according to claim 20, characterized in that it has in the intermediate layer (11) of the core (1) film capacitors (51/52) wired as buffer capacitors.

24. Printed circuit board according to one of the claims 20 to 23, characterized in that the core (1) has two core halves and on the side of one core half facing the core interior is provided a conductor layer (61) loaded with components (64) and that between the two core halves is provided a plastic filling layer structured in accordance with the loading.

25. Printed circuit board according to one of the claims 20 to 24, characterized in that it has as the outermost layer of the core (1) under the innermost conductor layer (21), comprising bonded foils, of the fine grid circuit, thin-film resistors (83), which are contacted with the conductor layer (21) by means of buried vias (28).

## Revendications

1. Procédé pour la fabrication de plaques de circuit multicouches par compression d'au moins deux produits intermédiaires avec des couches de pistes conductrices, caractérisé en ce que le circuit de la plaque est divisé en un circuit partiel pour une grille grosse et un circuit partiel pour une grille fine, en ce que les circuits de grille grosse et de grille fine sont posés séparément comme une ou plusieurs couches de pistes conductrices chacun, en ce qu'une partie au moins des couches de pistes conductrices du circuit de grille grosse (23, 24, 25) est réalisée sur des feuilles portant des couches conductrices et réunies pour former un premier produit intermédiaire et en ce qu'au moins un premier produit intermédiaire est réuni avec au moins un autre produit intermédiaire, qui comprend le circuit de grille fine et un noyau comprenant la plaque de circuit pour obtenir une épaisseur totale souhaitée, de telle sorte que le circuit de grille fine est disposé entre le circuit de grille grosse et le noyau.

2. Procédé selon la revendication 1, caractérisé en ce que la grille grosse correspond aux distances de contact d'éléments d'équipement et en ce que la grille fine est une grille de pistes conductrices quelconque, indépendante des distances de contact.

3. Procédé selon la revendication 1 ou 2, caractérisé en ce que les dimensions de grille de la grille grosse sont de 1,27 mm, les dimensions de grille de la grille fine de 160 »m.

4. Procédé selon l'une ou l'ensemble des revendications 1 à 3, caractérisé en ce que le premier produit intermédiaire est fabriqué par compression de plusieurs feuilles portant des couches conductrices, les couches conductrices des couches de pistes conductrices intérieures (23, 24) étant structurées en priorité, la couche conductrice de la couche de pistes conductrices extérieures (25) seulement après la compression des produits intermédiaires.

5. Procédé selon l'une ou l'ensemble des revendications 1 à 4, caractérisé en ce que le premier produit intermédiaire est pourvu de trous de contact traversants, qui sont plaqués après la compression des produits intermédiaires sous la forme de trous borgnes (26).

6. Procédé selon l'une ou l'ensemble des revendications 1 à 5, caractérisé en ce que pour la fabrication de l'autre produit intermédiaire, les couches de pistes conductrices (21 et 22) du circuit de grille fine sont formées une après l'autre par application d'une feuille à la fois sur une couche de noyau ou sur le noyau (1) ou sur une couche de pistes conductrices déjà appliquée, par création ultérieure de "*buried vias*" (27) sous la forme de contacts vers la couche de pistes conductrices sous-jacente ou vers la couche de noyau et enfin par report photochimique du plan et gravure de la couche conductrice.

7. Procédé selon l'une ou l'ensemble des revendications 1 à 5, caractérisé en ce que pour la fabrication de l'autre produit intermédiaire, les couches de pistes conductrices (21 et 22) du circuit de grille fine sont réalisées sur une feuille unique doublement stratifiée et en ce que la feuille structurée est pressée avec une couche de noyau ou le noyau (1).

8. Procédé selon l'une ou l'ensemble des revendications 1 à 7, caractérisé en ce qu'on utilise pour la fabrication des couches de pistes conductrices du circuit de grille fine et des couches de pistes conductrices du circuit de grille grosse, des feuilles à deux couches, qui se composent d'une couche conductrice (p. ex. 21.3) et d'une couche porteuse (p. ex. 21.2), ou des feuilles à trois couches, qui contiennent encore une couche de liaison entre la couche conductrice et la couche porteuse, et en ce que ces feuilles sont compressées entre elles avec une couche de liaison (p. ex. 21.1).

9. Procédé selon l'une ou l'ensemble des revendications 1 à 8, caractérisé en ce que le noyau (1) est produit par compression d'au moins trois couches, une couche intermédiaire (11) et deux feuilles de substrat (12.1 et 12.2).

10. Procédé selon l'une ou l'ensemble des revendications 1 à 8, caractérisé en ce que le noyau (1) est produit par compression de deux moitiés de noyau, une feuille de résistance (61) étant appliquée et structurée sur le côté de l'une des moitiés de noyau orienté vers l'intérieur du noyau avant la compression.

11. Procédé selon la revendication 10, caractérisé en ce qu'entre les deux moitiés de noyau, un remplissage de plastique supplémentaire au moins est compressé avec de la feuille de résistance appliquée et structurée.

12. Procédé selon l'une ou l'ensemble des revendications 1 à 11, caractérisé en ce que le noyau (1) est fabriqué sous la forme de deux moitiés de noyau, une couche de pistes conductrices (61) étant créée sur le côté d'une moitié de noyau orienté vers l'intérieur du noyau avant la compression et équipée de composants (64), et en ce que les deux moitiés de noyau sont compressées avec une couche de remplissage en plastique structurée d'une manière correspondant à l'équipement.

13. Procédé selon l'une ou l'ensemble des revendications 1 à 12, caractérisé en ce qu'avant l'application des couches conductrices (21 et 22) du circuit de grille fine sur la couche de noyau (12.1 ou 12.2), on applique une couche d'isolation (82) et, pardessus, des résistances en couche mince (83) et en ce que pour l'établissement du contact de ces résistances en couche mince (83) des "*buried vias*" (28) sont créées dans la couche de pistes conductrices intérieures(21) du circuit de grille fine.

14. Plaque de circuit multicouche fabriquée selon le procédé selon les revendications 1 à 13, caractérisée en ce qu'elle comporte un circuit partiel avec une grille grosse et un circuit partiel avec une grille fine, en ce que le circuit de grille grosse et le circuit de grille fine sont disposés chacun dans une ou plusieurs couches de pistes conductrices et en ce que le circuit de grille fine est disposé entre le circuit de grille grosse et un noyau (1) complétant la plaque de circuit jusqu'à une épaisseur totale souhaitée.

15. Plaque de circuit selon la revendication 14, caractérisée en ce que la grille des couches de pistes conductrices extérieures (23, 24 et 25) correspond aux distances de contact d'éléments d'équipement, mais la grille des couches de pistes conductrices intérieures (21 et 22) est plus fine.

16. Plaque de circuit selon l'une ou l'ensemble des revendications 14 ou 15, caractérisée en ce que les dimensions de grille de la grille grosse sont de 1,27 mm, et les dimensions de grille de la grille fine de 160 »m.

17. Plaque de circuit selon l'une ou l'ensemble des revendications 14 à 16, caractérisée en ce qu'elle présente sur les surfaces d'équipement des trous borgnes (26), qui traversent les couches de pistes conductrices extérieures (23, 24 et 25) et aboutissent sur la couche de pistes conductrices extérieures(22) du circuit de grille fine.

18. Plaque de circuit selon l'une ou l'ensemble des revendications 14 à 17, caractérisée en ce qu'il existe des "*buried vias*" (27) entre les couches de pistes conductrices (21 et 22) du circuit de grille fine.

19. Plaque de circuit selon l'une ou l'ensemble des revendications 14 à 18, caractérisée en ce qu'avec des couches de pistes conductrices bilatérales (2.1 et 2.2) le noyau (1) représente la moitié à un tiers du volume total de la plaque de circuit non équipée, et les trois quarts à deux tiers de ce volume avec une couche de pistes conductrices unilatérales (2.1 seulement).

20. Plaque de circuit selon l'une ou l'ensemble des revendications 14 à 19, caractérisée en ce qu'elle comporte un noyau (1), qui présente des éléments électriques, mécaniques ou thermiques disposés sur la surface du noyau ou à l'intérieur de celui-ci.

21. Plaque de circuit selon la revendication 20, caractérisée en ce qu'elle présente dans une couche intermédiaire (11) du noyau (1) des résistances en couche mince (63) montées comme des résistances de démarrage.

22. Plaque de circuit selon la revendication 20, caractérisée en ce qu'elle présente dans la couche intermédiaire (11) du noyau (1) des condensateurs (64) montés comme des condensateurs à puce.

23. Plaque de circuit selon la revendication 20, caractérisée en ce qu'elle présente dans la couche intermédiaire (11) du noyau (1) des condensateurs en feuille (51/52) montés comme des condensateurs tampons.

24. Plaque de circuit selon l'une ou l'ensemble des revendications 20 à 23, caractérisée en ce que le noyau (1) présente deux moitiés de noyau, une couche de pistes conductrices (61) équipée de composants (64) étant disposée sur le côté d'une moitié de noyau orienté vers l'intérieur du noyau, et une couche de remplissage en plastique structurée d'une manière correspondant à l'équipement étant prévue entre les deux moitiés de noyau.

25. Plaque de circuit selon l'une ou l'ensemble des revendications 20 à 24, caractérisée en ce qu'elle présente comme couche extérieure du noyau (1), sous la couche de pistes conductrices (21) la plus intérieure du circuit de grille fine composée de feuilles compressées, des résistances en couche mince (83), qui sont mises en contact au moyen de "*buried vias*" (28) avec la couche de pistes conductrices (21).
